# EUROPEAN PATENT APPLICATION

(11) **EP 1 251 524 A1**
(43) Date of publication of application: **23.10.2002**
(21) Application number: 01106379.9
(22) Date of filing: 19.03.2001
(51) Int. Cl.: G11C 16/22, G06K 19/073, G11C 5/00

(54) **Enhanced compact memory card with write protection**

(71) Applicant: POWER QUOTIENT INTERNATIONAL CO., LTD., Chung Ho City, Taipei Hsien (TW)
(72) Inventor: Lin, Tony, Taipei (TW)
(74) Representative: Helms, Joachim, Dipl.-Ing. Patentanwalt

(57) **Abstract**

An enhanced compact micro memory card with write protection, comprises an enclosed casing, and a switch circuit for data write protection. The enclosed casing provides a micro controller and a plurality of memories therein, and has a connector for external connection. The switch circuit for data write protection provides a micro switch with the micro switch accessible from the outside of the casing for switching the write protection operation.

## Description

### BACKGROUND OF THE INVENTION

### 1. Field of The Invention:

The present invention relates to an enhanced compact memory card with write protection, and particularly to a flash memory card providing enhanced function of write protection with an easily operated micro switch.

### 2. Description of Related Art:

Normally, most of the compact flash cards for commercial and industrial purposes have to equip a function of keeping the saved data for a long period of time. However, the compact flash cards themselves are short of a capability for data protection so that it is frequent that the important data are covered or deleted.

In order to revise the preceding shortcoming, it is necessary to add another function such as reconfirmation of command for data rewrite or delete at system end. But, it is not easy for all systems to meet the demand of adding this function.

Hence, a subject worth us to concern about is how to find out an appropriate way for write protection in a storage medium like the compact flash card such that the user is used to the operation thereof and a personal carelessness of user can be avoided

### SUMMARY OF THE INVENTION

An object of present invention is to provide an enhanced compact memory card with write protection, which offers a switch circuit and a micro controller to enable or disable the data protection by way of the operation of a micro switch easily.

### BRIEF DESCRIPTION OF THE DRAWINGS

The present invention can be more fully understood by referring to the following description and accompanying drawings, in which:
Fig. 1 is a block diagram of an enhanced compact flash card according to the present invention;
Fig. 2 is a perspective view of an enhanced compact flash card according to the present invention with the rear side being on top illustrating a micro switch being located at a lateral side thereof in a embodiment; and
Fig. 3 is a perspective view of an enhanced compact flash card according to the present invention with the rear side being on top illustrating the location of micro switch being located at a facial side thereof in another embodiment.

### DETAILED DESCRIPTION OF THE PREFERRED EMBODIMENTS

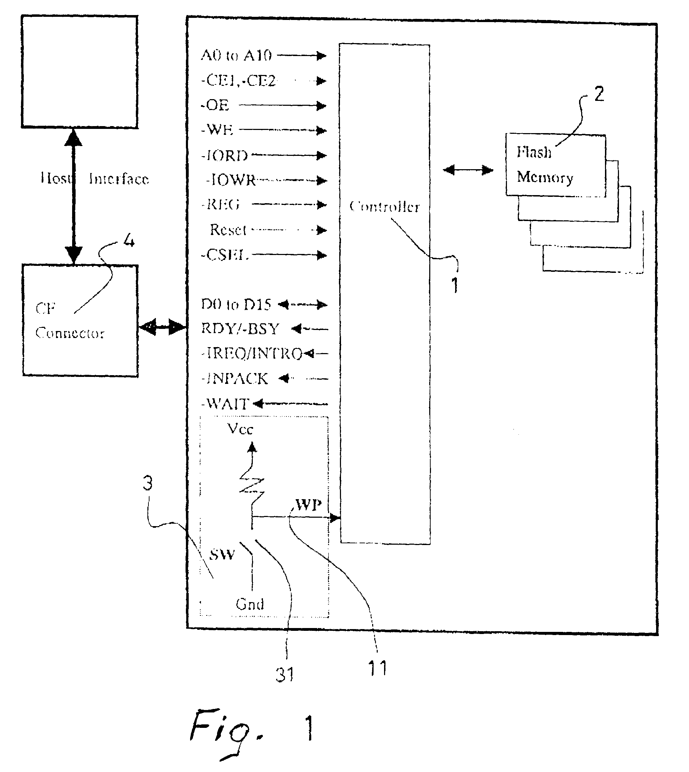

Referring to Fig. 1, basically an enhanced compact flash memory card of present invention basically comprises a micro controller 1, a plurality of flash memories 2, a switch circuit 3, and a connector 4.

Wherein, the micro controller 1 provides a function of decoding instructions such as reading, writing, and deleting coming from input data of a digital camera or the like to those instructions recognized by flash memories so that flash memories 2 connect with the micro controller 1. The connector 4 offers external connection, that is, a digital camera can externally connect with the connector 4 for signal transmission. Because these are prior art for a general actuation way of flash memories, no detail will be described further.

The characteristic of present invention resides in that the switch circuit 3 is added in the flash memory card so as to be operated by way of a micro switch 31. The switch circuit 3 and the micro controller 1 constitute a circuit to prevent data from being written into the card. The function of write protection can be enabled by way of the micro switch 31 and the micro controller 1 can sense whether the micro switch 31 has been set or not through a wire pin 11 with specific function. When the logic reference level "1" is sensed, it means the function of write protection is disenabled, and a digital camera can execute a function of write data into or delete data in the flash memories 2 by way of the micro controller 1 via the host interface. When the logic reference level "0" is sensed, it means the function of write protection is enabled, and the command of write or delete is terminated and the controller 3 feeds back a message of "command aborted" to the digital camera. Hence, a function of data protection can be performed so as to reach the purpose thereof.

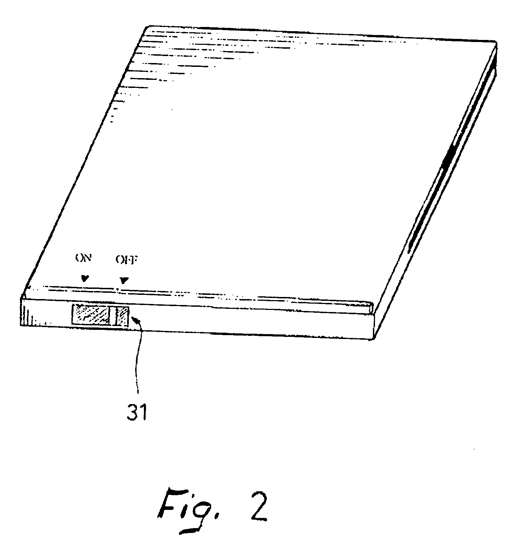

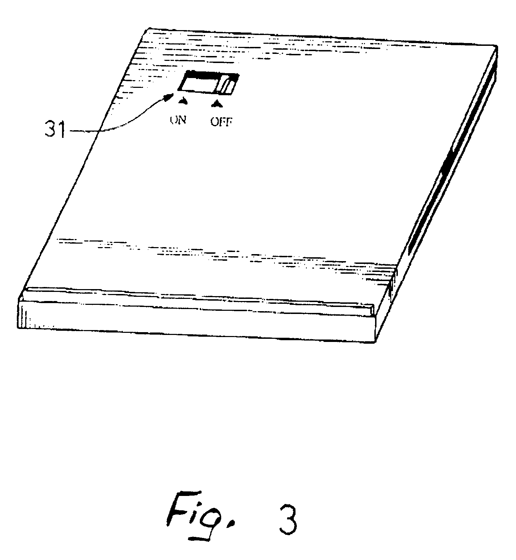

In order to allow the user being capable of setting the write protection in the memory card easily, the memory card of present invention is added a micro switch 31 such that the micro switch 31 can be shifted to change the status of the wire pin so as to perform the function of write protection. The micro switch 31 can be disposed either at a lateral edge on the memory card as shown in Fig. 2 or at the facial side or the rear side on the outer case of memory card as shown in Fig. 3 regardless of arranging the micro switch 31 at these two positions having the same function.

While the invention has been described with reference to preferred embodiments thereof, it is to be understood that modifications or variations may be easily made without departing from the spirit of this invention, which is defined by the appended claims.

## Claims

1. An enhanced compact memory card with write protection, comprising
an enclosed casing, providing a micro controller and a plurality of memories therein, and having a connector for external connection; and
a switch circuit of data write protection with a micro switch, the micro switch exposing outward the casing for switching a operation of write protection.

2. The enhance compact memory card with write protection according to claim 1, wherein a size thereof corresponds to a conventional micro flash memory card.

3. The enhance compact memory card with write protection according to claim 1, wherein the controller enables or disable the write protection of memory card by way of the micro switch being switched to change the reference level of potential or the magnitude of current.

4. The enhance compact memory card with write protection according to claim 1, wherein the write protection of memory card is enabled or disabled by way of the micro switch being switched to change the reference level of potential or the magnitude of current.

5. The enhance compact memory card with write protection according to claim 1, wherein the micro switch is disposed at a lateral edge of the outer casing.

6. The enhanced compact memory card with write protection according to claim 1, wherein the micro switch is disposed at a facial side of the casing.
